# DEMANDE DE BREVET EUROPEEN

(11) **EP 1 494 296 A1**
(43) Date de publication de la demande: **05.01.2005**
(21) Numéro de dépôt: 03405499.9
(22) Date de dépôt: 04.07.2003
(51) Int. Cl.: H01L 51/20, H05B 33/04

(54) **Dispositif électroluminescent**

(71) Demandeur: CFG S.A.Microelectronic, CH-1110 Morges (CH)
(72) Inventeur: Berner, Detlef, 1093 La Conversion (CH); Olmo, Olivier, 1110 Morges (CH)
(74) Mandataire: Ganguillet, Cyril

(57) **Abrégé**

Dispositif électroluminescent comprenant une diode électroluminescente organique (42) déposée sur un substrat en verre ou Si (41) et surmontée d'un couvercle (44) de protection; l'espace intérieur (45) de l'enceinte de protection (41,44) est rempli d'un matériau hydrophobe à l'état pâteux, dans lequel peut être dispersée une substance (46) capable de piéger H₂O. L'enceinte peut également contenir une substance (47), telle que Ca ou Li, capable de réagir avec des molécules O₂ ayant diffusé à l'intérieur de l'enceinte.

## Description

La présente invention concerne un dispositif électroluminescent comprenant une diode électroluminescente organique et une enceinte de protection, ladite diode comprenant une première électrode, une deuxième électrode et au moins une couche d'un matériau organique électroluminescent interposée entre lesdites deux électrodes, ladite enceinte comprenant une plaque portant la diode, en contact avec la première électrode, et un couvercle fixé à ladite plaque et recouvrant la diode de façon à assurer un écartement entre la deuxième électrode et ledit couvercle.

Les diodes électroluminescentes organiques, ou OLED, sont constituées d'une ou plusieurs couche(s) mince(s) de matériaux, dont l'épaisseur d'ensemble est de l'ordre de 100 à 200 nm, comprenant au moins un matériau organique électroluminescent, prise(s) en sandwich entre deux électrodes structurées ou non-structurées. En général, l'OLED est formé soit par des procédés d'évaporation/déposition, directement sur une plaque de substrat, tel qu'un verre ITO ou une matrice à base de Si, la ou les couche(s) formant la deuxième électrode étant déposée(s) en dernier, soit par spin-coating. La diode est à base soit de petites molécules, soit de polymères, soit un hybride des deux.

Les OLED sont extrêmement sensibles aux contacts directs, à l'oxygène atmosphérique ou autres gaz réactifs, à l'humidité, ainsi qu'aux vapeurs de solvants. En effet, H₂O et O₂ peuvent dégrader rapidement certains composants d'un OLED et raccourcir sensiblement sa durée de vie. C'est pourquoi il a été proposé d'encapsuler les OLED dans des enceintes de protection. En général, le substrat, sur lequel est déposé l'OLED, et en particulier s'il est réalisé en verre, forme l'une des parois de cette enceinte de protection.

Le brevet US 5,652,067 décrit un OLED protégé par une couche d'oxyde, de fluorure ou de sulfure métallique déposée sur la deuxième électrode, cette couche étant elle-même recouverte d'une couche d'adhésif photo-durcissable, à son tour recouverte d'un couvercle en verre ou en métal.

Le brevet US 5,047,687 propose de protéger un OLED en le recouvrant d'une couche protectrice comprenant un mélange de l'une des substances organiques du système organique électroluminescent et d'un métal présentant un potentiel électrochimique de 4 à 4,5 eV, susceptible d'être oxydé en présence d'humidité.

Les documents US 5,855,994, US 5,895,228 et US 5,952,778 décrivent des OLED protégés par des couches de résine polymérique à base de siloxane, en particulier des couches de résines photo-durcies.

Le document US 5,882,761 propose de former autour de l'OLED fixé à son substrat une enceinte étanche, par exemple une capsule de verre collée sur le substrat, confinant une atmosphère inerte. Une substance capable d'absorber de l'humidité est déposée à l'intérieur de la capsule, à distance de l'OLED.

Le document US 4,446,399 décrit un dispositif électroluminescent encapsulé entre deux substrats formant une cavité remplie d'un liquide protecteur, constitué d'huile ou de graisse silicone, capable de s'infiltrer dans les pores des couches diélectriques.

Le document US 5,962,962 décrit également une méthode d'encapsulation d'OLED, où l'enceinte est remplie d'un liquide inerte protecteur, constitué de perfluoroalcanes ou perfluoropolyethers. Le liquide peut contenir des adsorbants sous forme de poudres en suspension. Grâce à un dégazage préliminaire, ce liquide protecteur peut contenir moins de 1 ppm d'oxygène; mais il contient des quantités résiduelles d'H₂O de l'ordre de 5 à 20 ppm, susceptibles de diffuser rapidement au sein du liquide et d'endommager l'OLED. Par ailleurs, du fait d'une stabilité insuffisante de la suspension, un adsorbant, et en particulier un adsorbant saturé, peut s'accumuler à proximité de l'OLED.

Pour garantir une durée de vie suffisante de l'OLED, la concentration des impuretés, telles que H₂O, O₂, molécules de solvant, etc., doit être au plus de l'ordre de quelques ppm, ou de préférence inférieure au ppm, dans l'environnement immédiat de la diode.

Dans les dispositifs connus, les portions de surface des enceintes de protection constituées de lames de verre ou de métal peuvent être considérées comme des barrières suffisantes contre l'humidité ou l'oxygène atmosphérique. Le point faible des capsules enfermant une atmosphère inerte sous un couvercle collé est la résine servant à coller le couvercle au substrat. Une pièce intercalaire en matériau synthétique présente également une perméabilité non-nulle.

Par ailleurs, H₂O et O₂ sont capables de diffuser, en quantité faible mais non-négligeable, à travers les couches polymérisées qui enrobent les diodes, ou encore les couches de résine adhésive qui servent à coller les couvercles de capsules aux couches inférieures.

Le but de la présente invention est d'augmenter la fiabilité et la durée de vie d'OLED en améliorant leur protection contre la diffusion des molécules non-souhaitées (H₂O, O₂, solvants) et, simultanément, de simplifier et de rendre moins onéreuse la fabrication des enceintes de protection.

Ces buts sont atteints dans un dispositif électroluminescent du type défini d'entrée, grâce au fait que l'espace intérieur de l'enceinte est rempli d'au moins un matériau hydrophobe à l'état pâteux, chimiquement non-réactif vis-à-vis des matériaux de l'enceinte et de la diode, et que cet espace intérieur contient une substance capable de piéger H₂O.

Le matériau à l'état pâteux présente de préférence une viscosité mesurée selon la norme DIN 51804, comprise entre 130 et 400, et plus particulièrement entre 175 et 340, pour bien adhérer à l'OLED.

Ce matériau peut comprendre une ou plusieurs substance(s) choisie(s) parmi les polyphénylméthylsiloxanes, les polydiméthylsiloxane, les savons de lithium, les huiles fluorosilicones, les épaississants organiques, les épaississants PTFE, les épaississants inorganiques, les huiles silicones. Pour ralentir la diffusion d'impuretés, le matériau se présente sous forme d'un matériau pâteux, de consistance épaisse, choisi dans les classes NLGI 1 à 4.

Le remplacement de l'atmosphère gazeuse ou d'un milieu liquide à l'intérieur de l'enceinte par un matériau hydrophobe pâteux, de consistance épaisse, augmente la barrière de diffusion vis-à-vis de molécules telles que O₂ ou H₂O.

L'emploi d'un matériau pâteux permet de répartir de façon isostatique les pressions mécaniques que pourrait subir le dispositif en cas de manipulation violente ou de contraintes mécaniques, ce qui n'est pas le cas d'OLED recouverts exclusivement de matériaux solides, tels que des couches de résines photo-durcies.

Le matériau pâteux remplissant l'enceinte contribue au transport et à l'évacuation de la chaleur générée par le fonctionnement de la diode électroluminescente.

Le couvercle peut être constitué de verre, de métal ou d'une matière plastique. Il peut être venu d'une pièce, présenter la forme d'une boîte cylindrique, rectangulaire ou polygonale peu épaisse ou la forme d'une glace de montre concave. Le couvercle peut également être constitué d'un couvercle plan et d'une pièce intercalaire assurant un écartement entre la deuxième électrode de l'OLED et le couvercle plan. En particulier, l'une des pièces formant le couvercle ou la totalité de ce couvercle ainsi que le substrat sur lequel est fixé l'OLED peuvent être constitués de pièces flexibles basées sur une couche d'un matériau donné ou sur des assemblages multicouches.

L'invention permet aussi d'encapsuler des diodes évaporées/déposées sur un substrat flexible. Dans ce cas, on remplace le couvercle et la pièce intercalaire rigides par un couvercle et une pièce intercalaire flexibles. Le matériau pâteux supporte des déformations et des cisaillements que ne supporterait pas sans décollement et/ou destruction une structure composée de couches de polymères durcies.

L'invention permet aussi d'encapsuler des diodes transparentes ou translucides. Certains matériaux pâteux, notamment certaines graisses, sont translucides ou transparentes et ont des bons indices de réfraction, de sorte qu'on peut utiliser des dispositifs incorporant ces substances pour les affichages transparents ou translucides.

Pour rendre encore plus difficile la migration de molécules H₂O à travers le matériau hydrophobe, une substance capable de piéger ces molécules, soit par absorption physique, soit par réaction chimique, peut être dispersée dans le matériau hydrophobe pâteux. On peut utiliser des oxydes alcalins ou alcalino-terreux. Un oxyde préféré est l'oxyde de baryum. Certains sulfates, perchlorates ou halogénures métalliques conviennent également, ainsi que des substances organiques dessicatrices. On crée ainsi une triple barrière à la diffusion ou migration de H₂O : colle du couvercle + matériau hydrophobe + substance piégeante.

Pour empêcher la migration de molécules d'oxygène à travers le matériau pâteux hydrophobe, des substances réagissant avec l'oxygène, telles que des alcalins ou alcalino-terreux à l'état métallique, notamment Li, Ca, Na, Mg, peuvent être dispersées dans le matériau hydrophobe.

Du fait de la consistance du matériau pâteux hydrophobe, la ou les substance(s) piégeant H₂O et/ou O₂ sont maintenues en suspension sans sédimentation. Elles peuvent être concentrées à proximité des résines de collage du couvercle.

Pour piéger à la fois les molécules O₂ et H₂O, on peut disperser une substance piégeant H₂O et/ou O₂ dans le matériau hydrophobe pâteux et évaporer/déposer une molécule réagissant avec O₂ sur la face intérieure du couvercle : comme ce couvercle n'est pas sensible à la température d'évaporation/déposition du métal et comme il n'est pas en contact direct avec la diode organique, il n'y a pas de risque de destruction de la couche organique. La dispersion d'une poudre fine ou de molécules dans le matériau hydrophobe permet d'augmenter la surface réactive.

l'OLED peut être en contact direct avec le matériau hydrophobe pâteux. L'OLED peut également être surmonté d'une couche de protection isolante de faible épaisseur. Cette couche de protection peut être formée par toute technique de déposition appropriée, en soi connue. La couche de protection isolante peut être surmontée d'une deuxième couche protectrice active. Cette deuxième couche protectrice active peut être dopée par un métal à faible potentiel électrochimique de l'ordre de 2,8 à 4,5 eV, tel que Li, Ca, Na et Mg, capable d'être oxydé, dans l'éventualité où des molécules d'oxygène arriveraient à traverser la barrière constituée par le matériau pâteux hydrophobe.

La deuxième couche protectrice peut également être constituée d'une couche obtenue par évaporation/déposition d'un tel métal à l'état pur.

L'invention sera mieux comprise de l'homme du métier grâce à la description de sept modes d'exécution préférés de l'invention, en référence au dessin, dans lequel :
- la figure 1 est une vue schématique en coupe transversale d'un premier mode d'exécution d'un dispositif électroluminescent selon l'invention;
- la figure 2 est une vue schématique en coupe transversale d'un deuxième mode d'exécution du dispositif électroluminescent selon l'invention;
- la figure 3 est une vue schématique en coupe transversale d'un troisième mode d'exécution du dispositif électroluminescent selon l'invention;
- la figure 4 est une vue schématique en coupe transversale d'un quatrième mode d'exécution du dispositif électroluminescent selon l'invention;
- la figure 5 est une vue schématique en coupe transversale d'un cinquième mode d'exécution du dispositif électroluminescent selon l'invention;
- la figure 6 est une vue schématique en coupe transversale d'un sixième mode d'exécution du dispositif électroluminescent selon l'invention;
- la figure 7 est une vue schématique en coupe transversale d'un sixième mode d'exécution du dispositif électroluminescent selon l'invention.

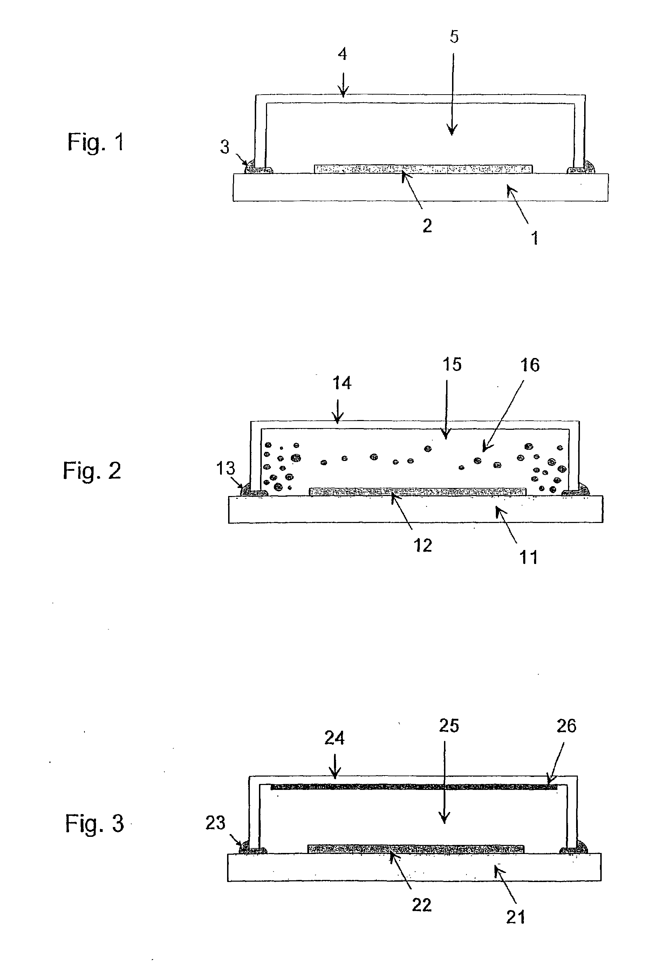

La figure 1 montre une plaque en verre 1 formant substrat. Sur la plaque en verre est déposé un OLED 2. l'OLED 2 est surmonté d'un couvercle 4 en verre, présentant la forme d'une boîte cylindrique peu épaisse. Le couvercle 4 est collé sur le substrat 1 à l'aide d'une résine photo-durcissable 3. Le substrat 1, le joint de résine photo-durcissable 3 et le couvercle 4 constituent ainsi une enceinte presque étanche, le joint de résine photo-durcissable 3 pouvant toutefois permettre la diffusion de faibles quantités de molécules H₂O ou O₂.

Tout l'espace intérieur 5 de l'enceinte est rempli d'une graisse à très faible tension de vapeur, formant une barrière à la diffusion des molécules H₂O. Le produit vendu sous la dénomination HVG High-Vacuum Grease/Dow Corning ®, qui est une graisse épaisse à base de silicone, utilisée habituellement pour l'étanchéité d'équipements devant fonctionner sous vide ou sous pression, convient parfaitement à cet usage. Il s'agit d'un matériau translucide, de consistance 185 (mesurée selon ASTMT217), pouvant être utilisé sans fondre de -40°C jusqu'à +200°C. Ce matériau ne s'oxyde pas à l'air, présente une excellente résistance vis-à-vis de l'eau et une grande inertie chimique.

Le tableau 1 présente une liste non exhaustive de produits, commercialement disponibles, susceptibles d'être employés à la place de la graisse HVG.

| Nom du produit testé | Viscosité selon DIN 51804 | Classe NLGI |
|---|---|---|
| 111 | 175 à 210 | 4 |
| DC340 | 245 à 300 | 2 à 3 |
| FS3452 | 240 à 280 | 2 à 3 |
| HVG (High Vacuum Grease) | 185 à 227 | 3 à 4 |
| 33light | 300 à 340 | 1 |
| FS1292 | 280 à 340 | 1 à 2 |
| DC7 | 270 à 322 | 1 à 2 |
| PG21 | 265 à 295 | 2 |

La figure 2 montre une plaque de verre 11 formant substrat. Sur la plaque en verre est déposé un OLED 12. L'OLED est surmonté d'un couvercle de protection 14 en matière plastique en forme de parallélépipède rectangle. Le couvercle 14 est collé au substrat de verre 11 par un joint de résine polymérisable à froid. De telles résines polymérisables à froid, à un ou à deux composants, sont disponibles dans le commerce. L'espace 15 entre le couvercle 14, le joint de résine 13 et le substrat 11 en verre est rempli d'une graisse épaisse comme dans le premier mode d'exécution. Dans cette graisse sont dispersées de fines particules 16 de BaO, destinées à piéger des molécules de H₂O qui auraient diffusé à travers le joint 13.

Selon une variante de ce deuxième mode d'exécution représenté à la figure 2, les particules de BaO sont plus nombreuses le long du périmètre de l'enceinte, c'est-à-dire à proximité du joint de résine 13, alors que la portion centrale de l'espace intérieur 15, c'est-à-dire la portion à proximité immédiate de l'OLED, contient moins de particules BaO, ou en est dépourvue.

La figure 3 montre une plaque en verre 21 formant substrat. Sur la plaque en verre est déposé un OLED 22. L'OLED 22 est surmonté d'un couvercle 24 en métal. Le couvercle 24 est collé sur la plaque 22 au moyen d'une résine photo-durcissable à froid à deux composants constituant un joint 23. L'espace intérieur 25 est rempli de la même graisse à vide que le premier mode d'exécution.

Pour piéger les molécules d'O₂ qui auraient diffusé dans l'espace 25 malgré la graisse, une couche 26 d'un métal oxydable, en l'espèce Li, est déposée par vaporisation sur la face intérieure du couvercle 24.

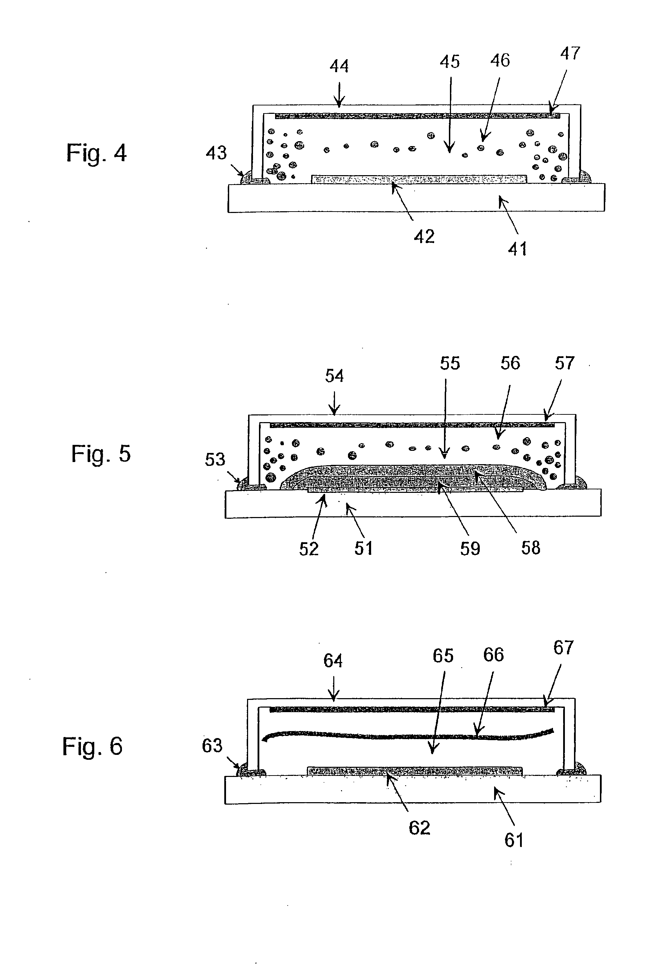

La figure 4 montre un quatrième mode d'exécution dans lequel une plaque en verre 41 porte un OLED 42. Sur la plaque 41 est scellé un couvercle 44 en aluminium au moyen d'un joint de résine photo-durcissable 43. Sur la face intérieure du couvercle 44 est déposée une couche 47 de magnésium susceptible d'être oxydée par de l'oxygène ayant diffusé à l'intérieur de l'enceinte. L'espace intérieur 45 est rempli de la même graisse à vide que dans les trois premiers modes d'exécution. Dans la graisse à vide sont dispersées des particules 46 constituées d'alumine Al₂O₃, pour piéger des molécules H₂O ayant diffusé dans l'enceinte.

La figure 5 montre un cinquième mode d'exécution. L'enceinte est constituée d'une plaque en verre transparent 51 surmontée d'un couvercle 54 collé sur la plaque 51 à l'aide d'une résine photo-durcissable 53. Sur la plaque 51 est disposé un OLED 52. L'OLED est surmonté d'une couche de protection isolante 59. La couche 59 est constituée de TiO₂. La couche 59 pourrait également être constituée d'autres oxydes TiOₓ ou SiOₓ, de nitrures ou d'une couche organique. La couche 59 est elle-même surmontée d'une couche 58 de métal présentant un niveau d'énergie d'extraction faible, de préférence 2,8 - 4,5 eV. La couche 58 peut notamment être constituée de lithium, de calcium, de sodium ou de magnésium, et elle est obtenue par évaporation/déposition selon un procédé connu. Par dessus cette structure de couches empilées 59, 58, l'espace intérieur 55 du dispositif est rempli de graisse à vide vers laquelle sont dispersées des particules de BaO. La face intérieure du couvercle 54 peut également porter une couche d'un des métaux précités.

La figure 6 montre un sixième mode d'exécution, dans lequel l'enceinte est constituée d'une plaque en verre transparent 61 sur laquelle est déposé un OLED 62. La plaque 61 est surmontée d'un couvercle métallique 64 collé sur la plaque 61 à l'aide d'une résine polymérisable à froid formant un joint 63. Sur la face intérieure du couvercle 64 est déposée une couche 67 de sodium métallique. L'espace intérieur 65 de l'enceinte est rempli de la même graisse que celle utilisée dans le premier mode d'exécution. Une lamelle 66 est en suspension dans la masse de graisse, en position approximativement parallèle à la plaque 61 et à distance aussi bien de l'OLED que de la face intérieure du couvercle 64. La lamelle 66 peut être une lamelle métallique, par exemple une lamelle d'aluminium ou de magnésium. Sur cette lamelle peut être déposée une fine couche de BaO ou d'Al₂O₃ destinée à piéger les molécules d'eau ayant diffusé à l'intérieur de l'enceinte. La lamelle 66 peut également être constituée entièrement de BaO ou d'Al₂O₃ et présenter une structure poreuse.

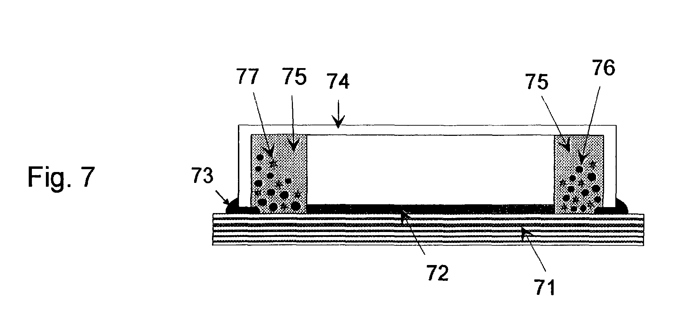

La figure 7 montre une matrice active à base de silicium 71 formant le substrat. Sur la matrice est déposé un OLED avec structure inversée 72. L'OLED 72 est surmonté d'un couvercle 74 en verre. Le couvercle 74 est collé sur la matrice à base de silicium au moyen d'une résine UV-durcissable formant un joint 73. L'espace intérieur 75 proche des bords est rempli de la même graisse à vide que le premier mode d'exécution. Dans cette graisse sont dispersées de fines particules de BaO, 76, et de Ca métallique, 77, destinées à piéger des molécules de H₂O et d'O₂ qui auraient diffusé à travers le joint 73.

On peut préparer le couvercle du dispositif selon l'invention avec au moins une couche qui contient des pièges (poudres de diverses valeurs de granulométrie, micro-gouttelettes de liquide réactif à oxygène, jusqu'à de grands morceaux ou des feuilles de matières réactives), et ceci indépendamment de la diode. Par la suite, on assemble les deux parties (couvercle + diode) ensemble, d'une manière qu'il ne reste pas de poches de gaz emprisonnées.

L'homme du métier pourra aisément réaliser d'autres modes d'exécution du dispositif électroluminescent selon l'invention telle que définie dans les revendications.

## Revendications

1. Dispositif électroluminescent comprenant une diode électroluminescente organique (2, 12, 22, 42, 52, 62) et une enceinte de protection, ladite diode comprenant une première électrode, une deuxième électrode et au moins une couche d'un matériau organique électroluminescent interposée entre lesdites deux électrodes, ladite enceinte comprenant une plaque (1, 11, 21, 41, 51, 61, 71) portant la diode, en contact avec la première électrode, et un couvercle (4, 14, 24, 44, 54, 64, 74) fixé (3, 13, 23, 43, 53, 63, 73) à ladite plaque et recouvrant la diode de façon à assurer un écartement entre la deuxième électrode et ledit couvercle, **caractérisé en ce que** l'espace intérieur (5, 15, 25, 45, 55, 65, 75) de ladite enceinte est rempli complètement ou partiellement d'au moins une couche d'un matériau hydrophobe à l'état pâteux, chimiquement non-réactif vis-à-vis des matériaux de l'enceinte et de la diode, et **en ce que** ledit espace contient au moins une substance capable de piéger H₂O.

2. Dispositif selon la revendication 1, **caractérisé en ce que** ledit matériau hydrophobe est une graisse épaisse, en particulier une graisse à vide, de viscosité comprise entre 130 et 400, en particulier entre 175 et 340, selon DIN 51804.

3. Dispositif selon l'une des revendications 1 ou 2, **caractérisé en ce que** ledit matériau hydrophobe comprend une ou plusieurs substance(s) choisie(s) parmi les polyphénylméthylsiloxanes, les polydiméthylsiloxane, les savons de lithium, les huiles fluorosilicones, les épaississants organiques, les épaississants PTFE, les épaississants inorganiques, huiles et graisses silicones.

4. Dispositif selon l'une des revendications précédentes, **caractérisé en ce qu'**une substance capable de piéger H₂O est dispersée (16, 46, 56, 76) dans ledit matériau hydrophobe.

5. Dispositif selon la revendication 4, **caractérisé en ce que** ladite substance capable de piéger H₂O est répartie de façon inhomogène dans ledit matériau hydrophobe, en particulier qu'elle est concentrée à proximité de la zone de contact entre ledit couvercle et ladite plaque.

6. Dispositif selon l'une des revendications 1 à 3, **caractérisé en ce qu'**une substance capable de piéger H₂O est disposée sur un support (66) dans ledit espace intérieur (65).

7. Dispositif selon l'une des revendications 4 à 6, **caractérisé en ce que** ladite substance capable de piéger H₂O est choisie parmi les oxydes de métaux alcalins, les oxydes de métaux alcalino-terreux, en particulier l'oxyde de baryum, les sulfates, halogénures et perchlorates de métaux.

8. Dispositif selon l'une quelconque des revendications précédentes, **caractérisé en ce que** ladite deuxième électrode est couverte d'au moins une première couche de protection (59) isolante.

9. Dispositif selon la revendication 8, **caractérisé en ce que** la première couche de protection (59) est recouverte d'au moins une deuxième couche de protection (58) active comprenant une substance capable de piéger O₂.

10. Dispositif selon la revendication 9, **caractérisé en ce que** ladite deuxième couche de protection (58) est dopée avec un métal de potentiel électrochimique compris entre 2,8 eV et 4,5 eV, en particulier le lithium.

11. Dispositif selon la revendication 9, **caractérisé en ce que** la deuxième couche de protection (59) est constituée d'un métal de potentiel électrochimique compris entre 2,8 eV et 4,5 eV, en particulier de lithium pur.

12. Dispositif selon l'une des revendications précédentes, **caractérisé en ce qu'**une substance capable de piéger O₂ est déposée en couche (26, 47, 57, 67) sur la face intérieure du couvercle (24, 44, 54, 64).

13. Dispositif selon l'une des revendications précédentes, **caractérisé en ce qu'**une substance capable de piéger O₂ est dispersée (77) dans ledit matériau hydrophobe.

14. Dispositif selon l'une des revendications précédentes, **caractérisé en ce que** le couvercle (5, 15, 25, 45, 55, 65) est venu d'une pièce.

15. Dispositif selon l'une des revendications précédentes, **caractérisé en ce que** les pièces constituant l'enceinte sont flexibles.

16. Dispositif selon l'une quelconque des revendications précédentes, **caractérisé en ce que** toutes les pièces et couches composant ledit dispositif sont transparentes dans une direction perpendiculaire à ladite plaque (1, 11, 21, 41, 51, 61).

17. Dispositif selon l'une quelconque des revendications précédentes, **caractérisé en ce que** la plaque de substrat est une matrice active à base de Si (71).
